# EUROPEAN PATENT APPLICATION

(11) **EP 1 978 407 A1**
(43) Date of publication of application: **08.10.2008**
(21) Application number: 07425181.0
(22) Date of filing: 28.03.2007
(51) Int. Cl.: G03F 7/00

(54) **Method for obtaining a transparent conductive film**

(71) Applicant: C.R.F. Società Consortile per Azioni, 10043 Orbassano (Torino) (IT)
(72) Inventor: Lambertini, Vito Guido, 10043 Orbassano (Torino) (IT); Li Pira, Nello, 10043 Orbassano (Torino) (IT); Bernard, Stefano, 10043 Orbassano (Torino) (IT); Grasso, Valentina, 10043 Orbassano (Torino) (IT)
(74) Representative: Notaro, Giancarlo

(57) **Abstract**

A method for obtaining a transparent conductive film (2a) comprises the steps of providing a transparent substrate (1), depositing a conductive film (2), of a thickness not greater than 5 µm, on the transparent substrate (1), and removing the entire thickness of conductive film (2) from portions of the surface of the substrate (1) in such a way that the residual parts (2a) of the conductive film (2) on the substrate define a pattern formed by lines of a width of between 1 nm and 2 µm, with distances between the adjacent lines of between 10 nm and 2 µm, said pattern being predetermined in such a way as to obtain a ratio between full spaces and empty spaces corresponding to a desired degree of optical transmittance for the conductive film.

## Description

The present invention relates to a method for obtaining a transparent conductive film.

The need to provide a transparent conductive film on a transparent substrate, made, for example, of glass or plastic material, exists in a wide range of fields. Examples of possible applications are displays of the "head-up" type for motor vehicles, so-called "touch-screens", electromagnetic-shielding devices, windows for fridges provided with anti-misting heaters, and so forth.

The purpose of the present invention is to provide a method for obtaining a transparent conductive film that is relatively simple, inexpensive, and efficient.

According to the general idea underlying the present invention, a method for obtaining a transparent conductive film is provided, characterized in that it comprises the steps of:
- providing a transparent substrate;
- depositing a conductive film, of a thickness not greater than 10 µm, on the transparent substrate; and
- removing the entire thickness of conductive film from portions of the surface of the substrate, in such a way that the residual parts of conductive film on the substrate define a pattern formed by lines of width of between 10 nm and 2 µm and with distances between adjacent lines of between 10 nm and 2 µm;
said pattern being predetermined in such a way as to obtain a ratio between full and empty spaces in the conductive film corresponding to a predetermined degree of optical transmittance desired for the conductive film.

According to the invention, removal of the parts of conductive film is obtained by means of an operation of etching through a mask (3a; 5a; 31; 2a) obtained by means of a technique chosen from amongst: nano imprinting lithography (NIL), µcontact printing, process of polymeric self-assembly, and process of formation of porous alumina.

The etching process consists in partial removal through a mask of a thin film deposited on a substrate. The material in the areas of the film not protected by the mask is removed by means of chemical or physical etching in a liquid environment (wet etching) or gaseous environment (plasma etching, reactive ion etching). The pattern of the mask is consequently transferred onto the thin film.

In a first embodiment, in which the aforesaid mask is obtained by means of a technique of nano imprinting lithography, a uniform conductive film is initially deposited on top of the substrate by means of vacuum techniques (thermal evaporation, sputtering, CVD) and liquid techniques (silk-screen printing, ink-jet technique, dipping), a polymeric material is applied on top of the conductive film by means of spin coating, a mould is provided with an active surface carrying nanometric incisions forming a pattern corresponding to the pattern that it is intended to transfer on the conductive film, said mould is applied with pressure on the polymeric material so as to obtain on the polymeric material a series of residual portions of polymeric material spaced apart from one another by empty spaces, and an operation of etching is carried out for removing the entire thickness of the conductive material, as far as the surface of the substrate, in positions corresponding the aforesaid empty spaces, in such a way that the residual portions of conductive film form the desired pattern on the substrate.

Preferably, the active surface of the mould has incisions arranged according to different geometries (lines, points, etc.) to form a structure with lines having a width of between 10 nm and 500 nm, the distance between adjacent lines being between 10 nm and 500 nm, and the depth of said incisions being between 100 nm and 1000 nm.

In a first example, the polymeric film is made of polymethylmethacrylate (PMMA), or of thermoplastic material and is heated during application under the mould to get it to assume the desired configuration. In an alternative example, the polymeric material is deposited in the form of drops of epoxy or acrylic resin and is made to crosslink during application of the mould by means of ultraviolet irradiation.

In applications designed for use as display, it is possible to provide a mould that has micrometric reliefs, each of which in turn has nanometric incisions, in order to obtain a display with areas of conductive film of micrometric dimensions each presenting a nanometric pattern.

According to a further characteristic, the mould used in the method according to the invention can be a rigid mould, made, for example, of silicon and quartz, or else even a flexible mould, made of PDMS C.

In an alternative process, a µcontact printing technique is employed, by providing said mould on its active surface with a layer of polymeric material, in such a way that, after application of the mould on top of the conductive layer, the conductive layer itself remains covered with portions of polymeric material spaced apart by empty spaces so that, in areas corresponding to said empty spaces, it is then possible to carry out subsequent removal of the entire thickness of the conductive layer, as far as the surface of the substrate, by means of etching.

In order to increase the "aspect ratio" (i.e., the ratio between full spaces and empty spaces of the conductive material on the surface), and consequently increase the conductivity given the same transmittance, in the step of plasma etching it is envisaged, according to a further characteristic of the invention, to use a nano-composite polymer with inclusions of metals and oxides with different selectivity. Said selectivity enables the metal layer to be dug more than the polymer layer, thus obtaining a structure having a higher aspect ratio. In the processes of plasma etching or reactive ion etching, the selectivity between the polymeric material and the film to be structured is low, hence leading to a similar erosion for the two materials, with the exclusion of certain combinations of materials (such as PMMA and Si) for which the selectivity can be high. In the majority of cases, starting from a polymeric film of 100-200 nm (typical for NIL and microcontact processes) the thickness that can be obtained on the conductive film is unlikely to exceed 300 nm. The inclusion of particles (such as gold, carbon, alumina, silicate, and the like) in the polymer produces an increase in the resistance in regard to the plasma-etching step.

In a further embodiment, the transparent conductive film is obtained by means of polymeric materials of the so-called self-assembling type. In this case, after deposition of the conductive film, for example, by means of PVD (Physical Vapour Deposition), silk-screen printing (SP), or ink-jet technique (IJ), said conductive film is coated with a thin polymer film in blocks, which, following upon phase separation (for example, induced with thermal treatment) undergoes self-assembly and assumes the desired configuration. By means of a subsequent operation, for example by means of application of ultraviolet rays, or else by thermal treatment, or by means of an operation of chemical removal, one of the two blocks of the polymer film is removed so that the structure comes to present a plurality of cavities arranged according to the desired configuration. With a further step of plasma etching, the aforesaid pattern is transferred onto the conductive film, the latter being removed as far as the substrate, through the aforesaid cavities. Of course, also in the case of said further embodiment, it is possible to combine the process to a step of micrometric imprinting for providing paths for use in applications such as displays.

According to yet a further embodiment, the conductive film is coated with a film of aluminium, which is subjected to an operation of anodization so that it undergoes self-assembly in a honeycomb structure. An operation of plasma etching through the pores of the alumina thus obtained enables removal of the conductive film as far as the substrate in areas corresponding to the aforesaid pores so as to obtain transfer of the desired pattern onto the conductive layer.

Further characteristics and advantages of the invention will emerge from the ensuing description with reference to the annexed plates of drawings, which are provided purely by way of non-limiting example and in which:
- Figures 1A, 1B, 1C and 2A, 2B, 2C show in parallel the sequence of steps of the method according to the invention, in two alternative examples of a first embodiment;
- Figure 3 illustrates the final step of the method according to the first embodiment of the invention, for both of the cases illustrated in Figures 1 and 2;
- Figure 4 is an example of pattern that can be obtained for the conductive film;
- Figure 5 illustrates application of a method according to the invention to a display;
- Figure 6 is a view at an enlarged scale of a detail of Figure 5;
- Figure 7A, 7B illustrate a detail of the mould used in the method for obtaining the display of Figure 5, in two variants for the NIL technique and for the microcontact technique, respectively;
- Figures 8A, 8B, 8C, 8D illustrate a further embodiment of the method according to the invention;
- Figure 9 is a schematic illustration of the structure of a composite polymer used in a further variant of the method according to the invention;
- Figures 10A, 10B1, 10B2, 10C1, 10C2, 10D1, 10D2 and 10E illustrate a further embodiment of the method according to the invention, in two possible variants; and
- Figures 11A, 11B, 11C, 11D illustrate a further embodiment of the method according to the invention.

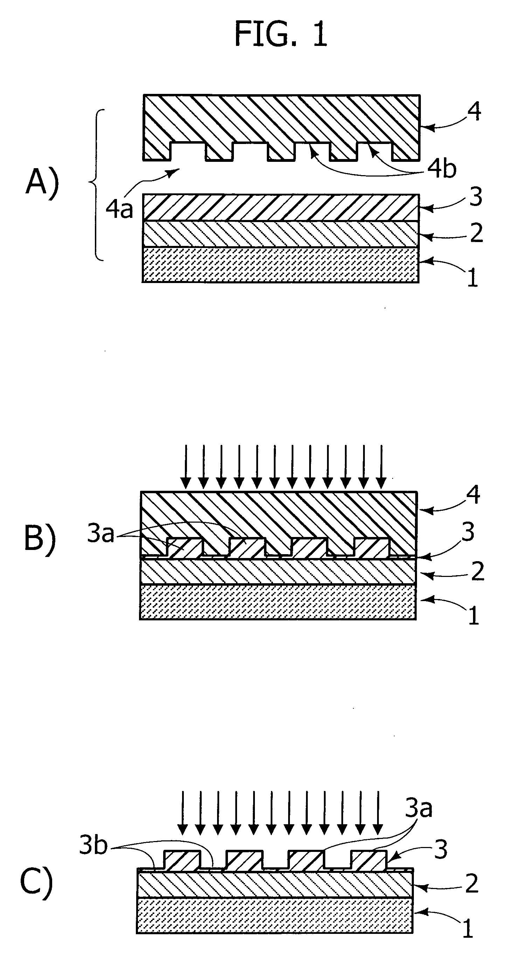

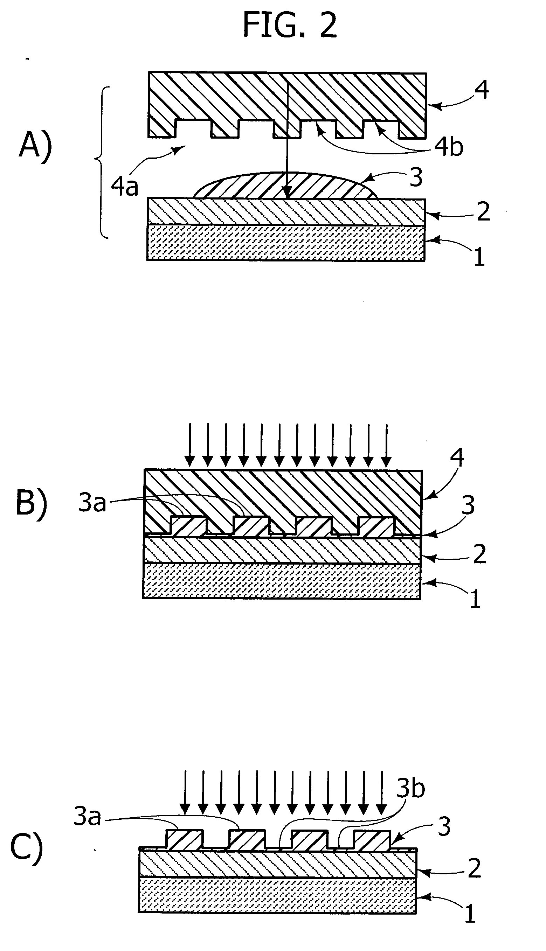

Figures 1 and 2 of the annexed drawings are schematic illustrations of two variants of a first embodiment of the method according to the invention, in which the desired pattern in the transparent conductive film on top of the transparent substrate is obtained by means of a process of nano imprinting lithography (NIL).

The methods illustrated in Figures 1 and 2 are substantially similar to one another and differ as regards the way with which the polymeric film to be applied on top of the conductive film is deposited and treated. In both cases the starting point is a rigid or flexible transparent substrate 1, for example made of glass or of plastic material. Likewise, in both cases, initially deposited on top of the transparent substrate 1 is a conductive film 2, for example made of metal (for instance, gold, silver or copper) or a semiconductor or an oxide. The film 2 is deposited by means of any technique of a known type, for example, by means of physical vapour deposition (PVD) or silk-screen printing, or with ink-jet technique. The thickness of the conductive layer is preferably between 0.5 µm and 10 µm.

Deposited on top of the conductive layer 2 is, in the case of the example illustrated in Figure 1A, a uniform layer 3 constituted by a polymeric film necessary for carrying out the process of nano imprinting lithography, for example a film of polymethylmethacrylate (PMMA), or a thermoplastic material. The thickness of the film 3 is preferably between 100 nm and 1000 nm. In the case of the variant illustrated in Figure 2A, which regards application of a process of nano imprinting lithography with ultraviolet rays (UV-NIL) a drop 3 of polymeric material is deposited, in particular an epoxy resin or an acrylic resin.

Both in the case of the example of Figure 1 and in the case of the example of Figure 2, moreover provided is a mould 4 that is rigid (for example, made of silicon or quartz) or flexible (for example, made of polydimethyl siloxane - PDMS), the active surface 4a of which bears incisions 4b defining the pattern that it is desired to transfer, by means of the layer of conductive material 2, onto the substrate 1. The incisions are arranged according to lines having a width of preferably between 10 nm and 500 nm. The distance between adjacent lines of incision is preferably also between 10 nm and 500 nm. Finally, the depth of the incisions 4b is preferably between 100 nm and 1000 nm.

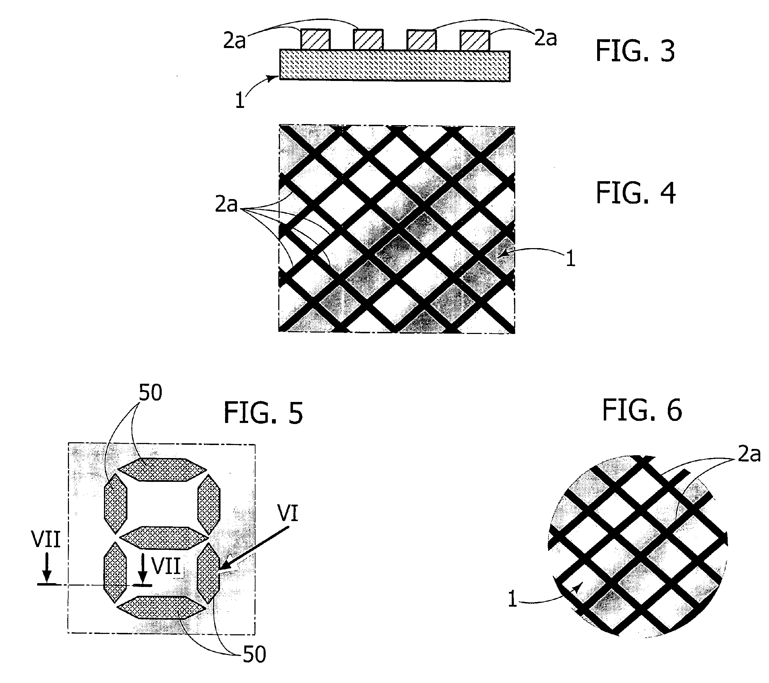

Both in the case of the method of Figure 1 and in the case represented in Figure 2 (see Figures 1B, 2B) the mould 4 is applied with pressure on top of the layer 3 of polymeric material. In the case of Figure 1B, the application of pressure (10-50 bar) can occur simultaneously to heating (up to 200°C), whilst, in the case of Figure 2B, the application of pressure (0.5 - 2 bar) occurs simultaneously to UV irradiation, which produces crosslinking of the resin 3. In this way, after removal of the mould 4, the pattern of the incisions 4b on the mould 4 is transferred onto the layer of polymeric material 3, which thus has projections 3a arranged according to the pattern of the furrows 4b of the mould. Between one projection 3a and the adjacent one, there remains a thin layer of polymeric material 3b constituting a barrier layer, which is removed by means of an operation of plasma etching or reactive ion etching (RIE). The product thus obtained is then subjected to an operation of etching so that, in the areas comprised between the projections 3a (Figures 1C, 2C), the layer of conductive material is removed for its entire thickness, as far as the surface of the substrate 1, whilst, in areas corresponding to the residual portions of polymeric material, only the polymeric material is removed, without removal of the conductive material of the layer 2. The product obtained with either of the methods of Figures 1, 2 is hence the one illustrated in Figure 3 and bears a pattern of the conductive material, for example, of the type shown in plan view in Figure 4. The pattern with which the residual conductive material 2a is transferred onto the substrate 1 corresponds to that of the incisions of the mould 4. By predetermining said pattern, it is possible to control the optical transmittance of the conductive film obtained, through a regulation of the ratio between full spaces and empty spaces in the conductive film.

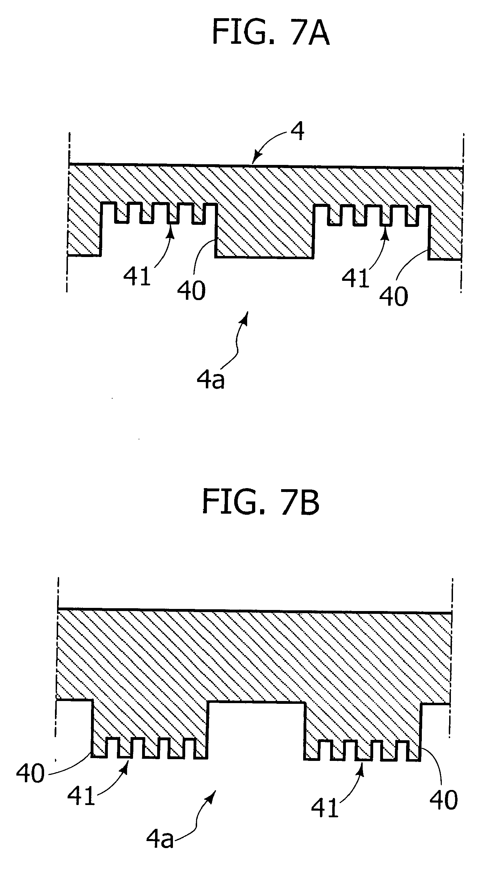

The process described above, both in the example illustrated in Figure 1 and in the example illustrated in Figure 2, can be applied for producing displays. Figure 5 shows a display the surface of which bears sub-areas 50 coated with a conductive film, obtained starting from a mould 4 of the type illustrated in Figure 7A (which represents a cross section according to the line VII-VII of Figure 5), where the active surface of the mould has micrometric reliefs 40, corresponding to the micrometric areas 50 of Figure 5, each of the reliefs 40 having a subnanometric structure 41 to enable, in areas corresponding to each of the sub-areas 50 of Figure 5, a deposition of conductive material to be obtained according to a pattern of the type illustrated in Figure 6.

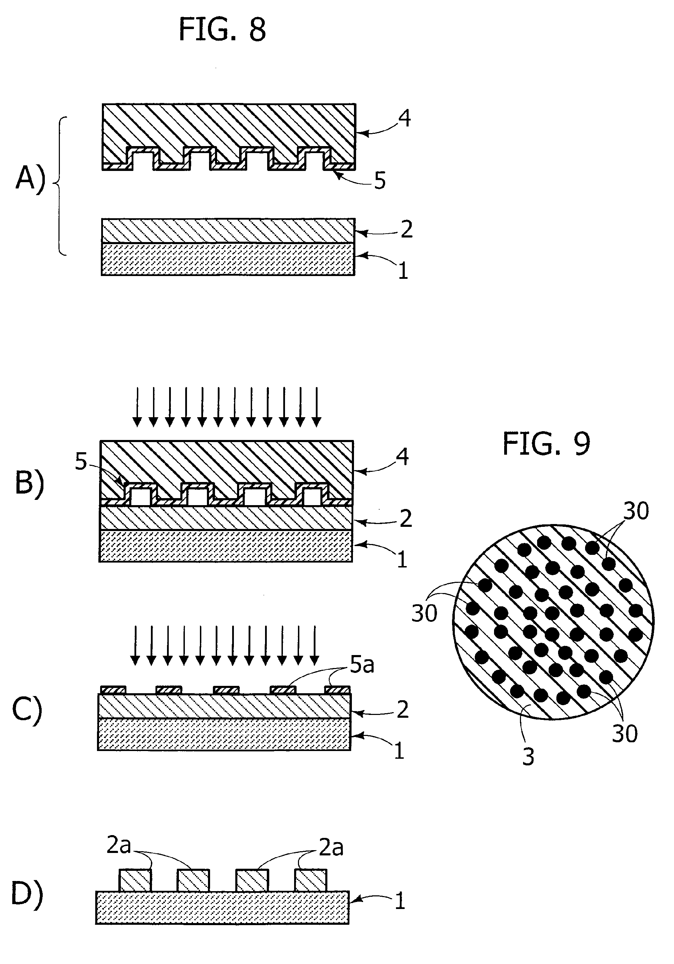

Figure 8 illustrates a second embodiment in which the pattern of the incisions of the mould 4 is transferred onto the conductive material 2 by means of a technique of µcontact printing. In this case, the active surface 4a of the mould 4 is provided with a layer 5 of polymeric material. The lines of the incisions in the surface 4a of the mould have a width of between 0.1 µm and 2 µm, and the distance between adjacent lines of incision is between 0.1 µm and 2 µm. In the case of the process of Figure 8, no deposition of polymeric layer on top of the conductive layer 2 is required. Once the mould 4 is applied with pressure on top of the conductive layer 2, on the latter there remain deposited portions 5a of polymeric material, whilst the free spaces between said residual portions 5a enable total removal, by means of etching, of the conductive layer for its entire thickness as far as the surface of the substrate in such a way that the final product obtained (Figure 8D) has residual portions of conductive material 2a arranged according to a pattern corresponding to that of the projections provided on the active surface 4a of the mould 4. Again, the arrangement of the conductive material thus obtained can be, for example, similar to the one illustrated in Figure 4.

In addition, also in the case of the method of Figure 8, said process can be applied for providing a nanometric pattern of the type illustrated in Figure 6 for the conductive material present in micrometric sub-areas 50 of a display, as illustrated above with reference to Figure 5 using a mould as shown in Figure 7B.

Both in the case of the method illustrated in Figure 1 and in the case of the method illustrated in Figure 2, as well as in the case of the method illustrated in Figure 8, it is possible to increase the aspect ratio, i.e., the ratio between the full spaces and the empty spaces in the conductive film, and consequently increase the conductivity, maintaining the transmittance substantially the same using a nanocomposite polymer with inclusions of metals and oxides with different selectivity. Said selectivity enables the metal layer to be dug more than the polymer layer in the step illustrated in Figures 1C, 2C and 8C so as to obtain a structure with higher aspect ratio. Figure 9 is a schematic illustration of the inclusions 30 that may be introduced in the polymeric material 3. Said inclusions can be filiform (for example, constituted by carbon nanotubes - CNTs), or else lamellar (constituted by mormorillonite or sepiolite), spherical (made of alumina, or silica, carbon C60, or metals) or be constituted by metallic particles of any shape.

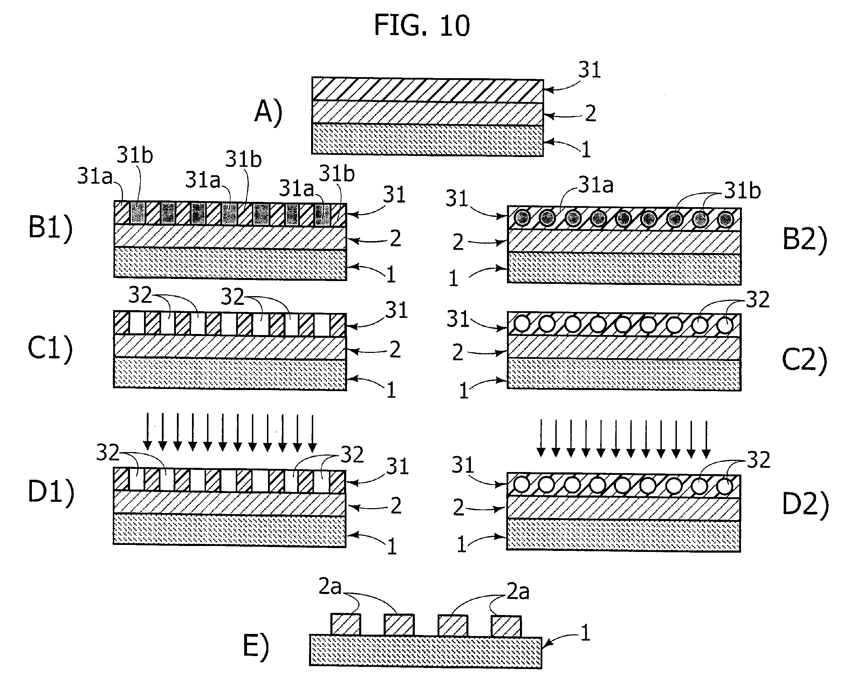

Figure 10 illustrates a further embodiment of the method according to the invention in which the conductive film 2 is coated with a thin polymer film in blocks, which, following upon phase separation (for example, induced with thermal treatment) undergoes self-assembly and assumes a pre-determined pattern. Figures 10B1 and 10B2 illustrate two examples in which the polymeric layer 3 is transformed into a layer 31 having blocks 31a, 31b of two different types. A subsequent operation, obtained, for example, by means of UV irradiation, or else by means of application of heat, or else by means of chemical removal, enables removal of one of the two blocks (block 31b with reference to the figures), so that the product obtained (Figures 10C1 and 10C2) has empty spaces 32 arranged according to a pre-determined pattern. At this point, said pattern can be transferred onto the conductive film by means of an operation of plasma etching, which enables removal of the entire thickness of the conductive layer 2, as far as the substrate 1, in areas corresponding to the empty spaces 32. There is thus obtained once again a structure of the type illustrated in Figure 10E, which bears residual portions of conductive material distributed according to a pattern for example of the type illustrated in Figure 4.

Also in the case of the method of Figure 10, of course, it is possible to envisage combining said process with a step of micrometric imprinting for providing a nanometric pattern of the type illustrated in Figure 6 for the micrometric sub-areas 50 of a display.

In addition, in the case of Figure 10, it is possible to envisage using a self-assembling polymer with nanometric inclusions as in Figure 9 for increasing the selectivity in the etching step.

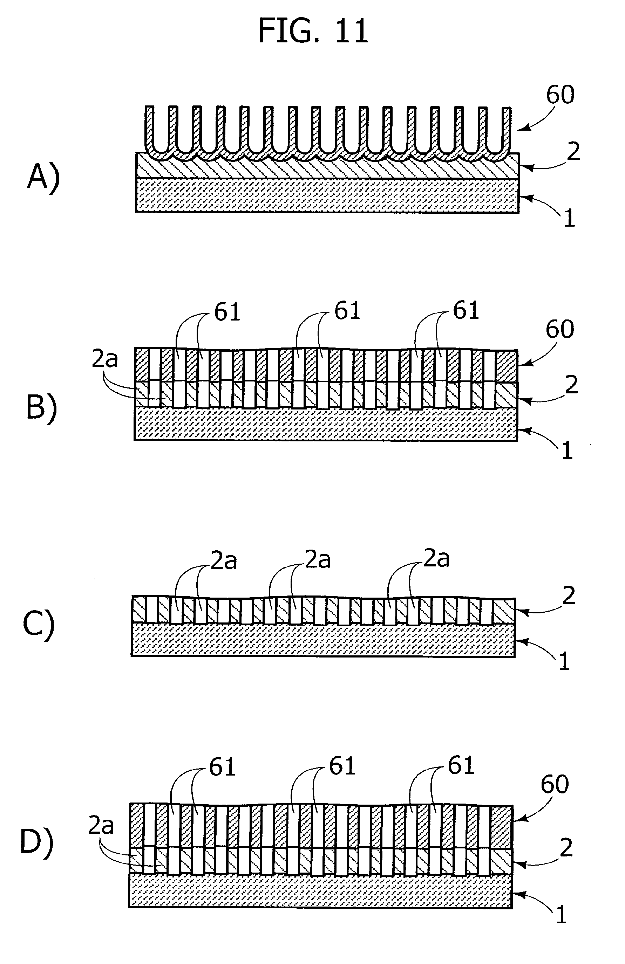

Figure 11 illustrates a further embodiment of the method according to the invention, in which the conductive film 2 is coated with a film of aluminium that is subjected to an operation of anodization in such a way as to be converted into a layer of porous alumina 60 with a honeycomb structure of the type visible in Figure 11A. Said structure has a plurality of cavities 61, arranged according to a pre-determined pattern, and closed on the bottom by a barrier layer, which is removed by means of an operation of plasma etching so as to obtain a corresponding removal of the entire thickness of the conductive material 2, as far as the surface of the substrate 1, in areas corresponding to the cavities 61 (Figure 11B). At this point, the layer of porous alumina is removed (Figure 11C), and the layer of the conductive film, which initially had a thickness of between 100 nm and 500 nm, is increased up to a thickness of 0.5-5 µm by means of an electro-plating operation.

As is evident from the above description, in all of the embodiments of the method according to the invention a conductive film is deposited on top of a transparent substrate, and the entire thickness of the conductive film is then removed from portions of the surface of the transparent substrate, in such a way that the residual parts of conductive film on the substrate define a pre-determined pattern, which corresponds to a ratio between full spaces and empty spaces in the conductive film defining a degree of optical transmittance desired for the product obtained.

Of course, without prejudice to the principle of the invention, the embodiments and the details of construction may vary widely with respect to what is described and illustrated herein purely by way of example, without thereby departing from the scope of the present invention.

## Claims

1. A method for obtaining a transparent conductive film, **characterized in that** it comprises the steps of:
- providing a transparent substrate (1);
- depositing a conductive film (2), of a thickness not greater than 10 µm, on the transparent substrate (1); and
- removing the entire thickness of conductive film (2) from portions of the surface of the substrate (1) in such a way that the residual parts (2a) of conductive film (2) on the substrate define a pattern formed by lines having a width of between 10 nm and 2 µm, with distances between adjacent lines of between 10 nm and 2 µm, said pattern being predetermined in such a way as to obtain a ratio between full spaces and empty spaces corresponding to a desired degree of optical transmittance.

2. The method according to Claim 1, **characterized in that** removal of the parts of conductive film is obtained by means of an operation of etching through a mask (3a; 5a; 31; 2a) obtained by means of a technique chosen from amongst: nano imprinting lithography (NIL), µcontact printing, process of polymeric self-assembly, and process of formation of porous alumina.

3. The method according to Claim 2, in which the aforesaid mask is obtained by means of technique of nano imprinting lithography, **characterized in that** a uniform conductive film (2) is initially deposited on top of the substrate (1), a polymeric material (3) is applied on the conductive film (2), a mould (4) is provided with an active surface (4a) carrying nanometric incisions forming a pattern corresponding to the pattern that it is intended to provide with the conductive film, said mould (4) is applied with pressure on the polymeric material so as to obtain on the polymeric material a series of residual portions (3a) of polymeric material spaced apart by empty spaces, and an operation of etching is carried out for removing the entire thickness of the conductive material (2), as far as the surface of the substrate (1), in areas corresponding to the aforesaid empty spaces, in such a way that the residual portions (2a) of conductive film form the desired pattern on the substrate.

4. The method according to Claim 3, **characterized in that** the active surface (4a) of the mould (4) has incisions arranged according to lines of a width of between 10 nm and 500 nm, the distance between adjacent lines being between 10 nm and 500 nm, and the depth of said incisions being between 100 nm and 1000 nm.

5. The method according to Claim 3, **characterized in that** the mould (4) is made of rigid material, preferably silicon or quartz.

6. The method according to Claim 3, **characterized in that** the mould is made of flexible material, and is preferably made of polydimethyl siloxane (PDMS).

7. The method according to Claim 3, **characterized in that** the polymeric film (3) is made of polymethylmethacrylate (PMMA), or of thermoplastic material.

8. The method according to Claim 7, **characterized in that** the conductive film (2) is deposited by means of a technique chosen from among physical vapour deposition (PVD), silk-screen printing, and ink-jet technique.

9. The method according to Claim 3, **characterized in that** the polymeric material is constituted by an epoxy or acrylic resin and **in that** application of the mould (4) on the polymeric material occurs under pressure and with simultaneous ultraviolet irradiation for bringing about crosslinking of the resin.

10. The method according to Claim 3, **characterized in that**, after removal of the mould, a thin barrier layer (3b) of polymeric material that closes at the bottom each of the empty spaces between the residual portions (3a) of polymeric material is removed by means of an operation of plasma etching or reactive ion etching (RIE).

11. The method according to Claim 2, **characterized in that** it is used for providing a nanometric pattern in micrometric sub-areas (50) of conductive film of a display structure.

12. The method according to Claim 2, **characterized in that** a µcontact-printing technique is used, providing said mould (4) on its active surface (4a) with a layer (5) of polymeric material, in such a way that, after application under pressure of the mould on top of the conductive layer (2), the conductive layer (2) remains covered with portions of polymeric material (5a) separated by empty spaces, and in areas corresponding to said empty spaces removal of the entire thickness of the conductive layer (2) is then carried out, as far as the surface of the substrate (1), by means of an etching operation.

13. The method according to Claim 3 or Claim 12, **characterized in that** the polymeric material is a nanocomposite material with inclusions of metals and/or oxides, such as carbon nanotubes (CNTs), lamellae of mormorillonite or sepiolite, spherical inclusions of alumina, silica, carbon C60, or metallic particles of any shape.

14. The method according to Claim 2, **characterized in that** the conductive film (2) is coated with a thin polymer film in blocks and **in that** an operation is carried out for inducing a phase separation in said polymer in blocks in such a way that it undergoes self-assembly into two separate blocks (31a, 31b) according to a pre-determined pattern, said method comprising a further operation of removal of one of the two blocks (31a, 31b) so that the resulting empty spaces are used for obtaining a removal of the entire thickness of conductive material in areas corresponding to said empty spaces, by means of an etching operation.

15. The method according to Claim 10, **characterized in that** the aforesaid mask (60) used for carrying out the operation of removal of the conductive layer from portions of the substrate is provided by depositing a layer of aluminium and subjecting it to an operation of anodization so as to obtain a honeycomb structure of porous alumina (60) with empty spaces (61) closed at the bottom by a barrier layer, which is removed by means of an operation of plasma etching, so as to give rise to a structure with through cavities (61), which is used for removing the entire thickness of the conductive material as far as the surface of the substrate (1), in areas corresponding to the aforesaid cavities (61), after which the layer of alumina (60) is removed, and the conductive layer is increased in thickness by means of an electro-plating operation.

## Amended claims

### Amended claims in accordance with Rule 137(2) EPC.

**1.** A method for obtaining a transparent conductive film in a display, which comprises the steps of:
- providing a transparent substrate (1);
- depositing a conductive film (2) on the transparent substrate (1); and
- removing the entire thickness of conductive film (2) from portions of the surface of the substrate (1) in such a way that the residual parts (2a) of conductive film (2) on the substrate define a pattern,
**characterized in that** said conductive film (2) is an opaque conductive film of a thickness not greater than 10 µm, said pattern obtained in said film (2) being formed by lines having a width of between 10 nm and 2 µm, with distances between adjacent lines of between 10 nm and 2 µm, said pattern being predetermined in such a way as to obtain a ratio between full spaces and empty spaces corresponding to a desired degree of optical transmittance.

**2.** The method according to Claim 1, **characterized in that** it is applied to the production of a head-up display.

**3.** The method according to Claim 1, **characterized in that** removal of the parts of conductive film is obtained by means of an operation of etching through a mask (3a) obtained by means of nano imprinting lithography, **wherein** a uniform conductive film (2) is initially deposited on top of the substrate (1), a polymeric material (3) is applied on the conductive film (2), a mould (4) is provided with an active surface (4a) carrying nanometric incisions forming a pattern corresponding to the pattern that it is intended to provide with the conductive film, said mould (4) is applied with pressure on the polymeric material so as to obtain on the polymeric material a series of residual portions (3a) of polymeric material spaced apart by empty spaces, and an operation of etching is carried out for removing the entire thickness of the conductive material (2), as far as the surface of the substrate (1), in areas corresponding to the aforesaid empty spaces, in such a way that the residual portions (2a) of conductive film form the desired pattern on the substrate.

**4.** The method according to Claim 3, **characterized in that** the active surface (4a) of the mould (4) has incisions arranged according to lines of a width of between 10 nm and 500 nm, the distance between adjacent lines being between 10 nm and 500 nm, and the depth of said incisions being between 100 nm and 1000 nm.

**5.** The method according to Claim 3, **characterized in that** it is used for providing a nanometric pattern in micrometric sub-areas (50) of conductive film of a display structure.

**6.** The method according to Claim 1, **characterized in that** removal of the parts of conductive film is obtained by means of an operation of etching through a mask (3a) obtained by means of a µcontact-printing technique, providing said mould (4) on its active surface (4a) with a layer (5) of polymeric material, in such a way that, after application under pressure of the mould on top of the conductive layer (2), the conductive layer (2) remains covered with portions of polymeric material (5a) separated by empty spaces, and in areas corresponding to said empty spaces removal of the entire thickness of the conductive layer (2) is then carried out, as far as the surface of the substrate (1), by means of an etching operation.

**7.** The method according to Claim 6, **characterized in that** it is used for providing a nanometric pattern in micrometric sub-areas (50) of conductive film of a display structure.

**8.** The method according to Claim 1, **characterized in that** the conductive film (2) is coated with a thin polymer film in blocks and **in that** an operation is carried out for inducing a phase separation in said polymer in blocks in such a way that it undergoes self-assembly into two separate blocks (31a, 31b) according to a pre-determined pattern, said method comprising a further operation of removal of one of the two blocks (31a, 31b) so that the resulting empty spaces are used for obtaining a removal of the entire thickness of conductive material in areas corresponding to said empty spaces, by means of an etching operation.

**9.** The method according to Claim 8, **characterized in that** it is used for providing a nanometric pattern in micrometric sub-areas (50) of conductive film of a display structure.

**10.** The method according to Claim 1, **characterized in that** removal of the parts of conductive film is obtained by means of an operation of etching through a mask (3a) obtained by depositing a layer of aluminium and subjecting it to an operation of anodization so as to obtain a honeycomb structure of porous alumina (60) with empty spaces (61) closed at the bottom by a barrier layer, which is removed by means of an operation of plasma etching, so as to give rise to a structure with through cavities (61), which is used for removing the entire thickness of the conductive material as far as the surface of the substrate (1), in areas corresponding to the aforesaid cavities (61), after which the layer of alumina (60) is removed, and the conductive layer is increased in thickness by means of an electro-plating operation.
